Europäisches Patentamt

European Patent Office

Office européen des brevets

(11) Publication number: **0 047 597**
**A1**

(12) **EUROPEAN PATENT APPLICATION**

(21) Application number: **81303801.5**

(22) Date of filing: **20.08.81**

(51) Int. Cl.³: **G 01 R 31/02,** G 01 R 31/12,
G 01 R 31/18, B 29 F 3/04

(30) Priority: **04.09.80 GB 8028558**

(43) Date of publication of application: **17.03.82**
**Bulletin 82/11**

(84) Designated Contracting States: **AT BE CH DE FR GB IT**
**LI LU NL SE**

(71) Applicant: **WIRSBO BRUKS AKTIEBOLAG,**
**S-730 61 Virsbo (SE)**

(72) Inventor: **Imgram, Friedrich, WIRSBO PEX GmbH Post**
**Box 1128, D-6056 Heusenstamm/Offenbach (DE)**

(74) Representative: **Evans, David Charles et al, F.J.**
**CLEVELAND & COMPANY 40-43, Chancery Lane,**
**London, WC2A 1JQ (GB)**

(54) **Improvements in and relating to the testing of pipes.**

(57) In a method of forming a shaped article (12) of a cross-linked polyolefinic material by forming a mixture of a thermoplastic olefinic material capable of forming a free radical with a crosslinking agent therefor, working the material under pressure in a shaping and crosslinking apparatus to produce uniform temperature rise within the mixture to a temperature at which the material can be extruded but at which substantial cross-linking does not occur, and thereafter shaping the material and initiating the cross-linking reaction and allowing the cross-linking reaction to proceed substantially to completion, the invention provides the improvement of subjecting the cross-linked material on leaving said apparatus to a high voltage of at least 1000 volts at a temperature greater than 100°C. to detect non-activated free valencies thereby providing an indication of the degree of crosslinking.

The invention also provides an apparatus (17) including means for heating a cross-linked polyolefinic material to a temperature in excess of 100°C. means for applying a voltage above 1000 volts across said material, and means (23) for indicating any discharge occuring across said material.

- 2 -

## DESCRIPTION

The present invention relates to the testing of pipes formed of a plastics material and has particular reference to the testing of cross-linked polyolefinic pipe for quality control and dimensional stability.

The manufacture of cross-linked polyolefinic pipe is generally known from British Patent Specification No:1,158,011 by a process which comprises mixing a thermoplastics material capable of forming a free radical with a cross-linking agent wherein a mixture of thermoplastics material and cross-linking agent is subjected to instantaneous compression under conditions such that substantial cross-linking of the thermoplastics material does not occur and thereafter shaping the mixture and causing or allowing the cross-linking of the shaped material to take place.

The pipe and tube manufactured in accordance with this process are now generally well known. Such pipes are now widely used in hot water applications such as for hot water supply pipes and also in central heating systems.

For use at elevated temperatures such pipe must be free of flaws and imperfections. The presence of small air bubbles, impurities such as dust or dirt result in a degradation of the pipe and eventually, under the conditions of use at elevated temperatures, deformation and subsequent leakage.

- 3 -

In order to maintain the quality of the pipe, therefore, it is necessary to provide means of testing which will ensure uniformity of wall thickness and to indicate immediately the presence of foreign matters such as dust, dirt and air bubbles. This may be conveniently effected by use of a device along the lines disclosed in U.S. Patent No: 3710241 which reveals a method of detecting faults or discontinuities in the insulating or dielectric properties of an extruded tube. A high voltage potential is established between a ring which surrounds the tube as it emerges from the extrusion die and the extrusion core. Any conduction between the ring and the core unbalances the bridge network which then activates a relay to indicate the presence of a fault or discontinuity. A die or paint sprayer or a warning device may also be controlled by the relay to mark the location of the fault or defect. This method suffers from the disadvantage that it cannot assess the degree of crosslinking of a crosslinked polyolefinic material. The Applicants have now found that the above type of device can be used to provide an indication of crosslinking if the material is first raised to a temperature above $100^{o}C$. According to the present invention, therefore, there is provided a method of testing the degree of crosslinking of an extruded crosslinked polyolefinic material which method comprises subjecting the material to a voltage above 1000 volts at a temperature above $100^{o}C$. in order to detect non-activated free valencies thereby providing an indication of the degree of crosslinking of the material.

- 4 -

In another aspect of the invention, there is provided a method of forming a shaped article of a crosslinked polyolefinic material by forming a mixture of a thermoplastic olefinic material capable of forming a free radical with a crosslinking agent therefor, working the material under pressure in a shaping and crosslinking apparatus to produce a uniform temperature rise within the mixture to a temperature at which the material can be extruded but at which substantial crosslinking does not occur, and thereafter shaping the material and initiating the crosslinking reacting and allowing the crosslinking reaction to proceed substantially to completion; the improvement comprising subjecting the crosslinked material on leaving said apparatus to a high voltage of at least 1000 volts at a temperature greater than $100^{\circ}C.$ to detect non-activated free valencies thereby providing an indication of the degree of crosslinking.

The temperature of the material, which is preferably in tubular form (pipe) is preferably greater than the temperature at which the pipe will normally be used, ie: if the pipe is to be employed at a temperature of say $90^{\circ}C.$ in a hot water system, then the temperature of testing will be a little more than $100^{\circ}C.$

The voltage applied by the voltage means is preferably the voltage which is just below the level at which discharge will occur for a normal sound wall of a desired degree of crosslinking at a given test temperature. Thus, if a pipe wall were entirely satisfactory crosslinked and completely free of bubbles, dust particles and the like and the wall thickness were such that a voltage of 25,000 volts would cause a discharge, then the test voltage would be a little below that, say, 24,500 volts so that any imperfection in the degree of crosslinking or reduction of wall thickness for example results in a discharge and the alarm being given.

In a preferred embodiment of the present invention the spark chamber is disposed immediately downstream of the forming die so that the hot material passes from the forming die into the spark tester for testing before solidification. The temperature of the material entering the spark chamber will be high and imperfections will be more readily sensed. Where the material has been cooled and formed into coils and it is desired to test the material after formation into coils, the inner electrode may be a heated conducting liquid which is applied to one end of the material passing through the spark chamber thereby to both heat the material to more than 100°C and to provide the electrode.

In an alternative embodiment of the invention the inner electrode may be a metal rod or bar disposed within the tube. The exterior electrode may comprise a plurality of brush fibres formed of copper or chains extending over the circumference of the pipe. It is preferred that the pipe moves relative to the first and second electrodes, the second electrode serving to sense the whole circumference of the pipe during its passage therethrough.

The method of the present invention permits the control,to within close limits,of the wall thickness and wall quality of an extruded plastics pipe.as well as the degree of crosslinking.

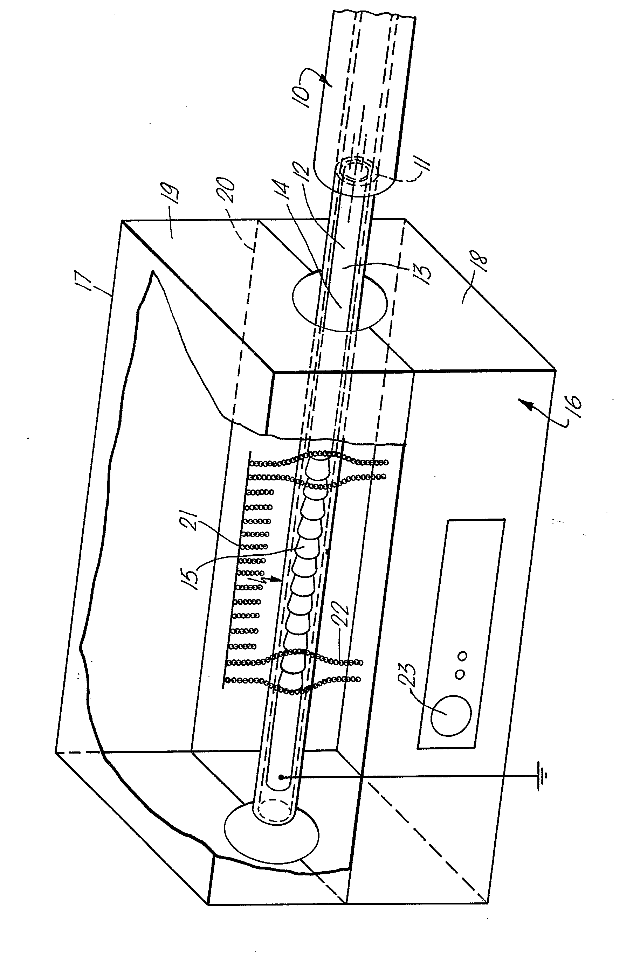

Following is a description by way of example only and with reference to the accompanying drawing of an embodiment in accordance with the present invention.

The drawing is a diagrammatic representation of a spark chamber juxtaposed an extruder die in accordance with the present invention.

In the drawing, an extrusion die 10 has an outlet orifice 11 from which a length of cross-linked polyethylenic pipe 12 issues at an elevated temperature; the pipe having been manufactured generally in accordance with British Patent Specification No: 1,158,011. The pipe 12 enters over a first electrode member 13 formed by a longitudinal cylindrical bar 14 having toward the centre thereof a plurality of frusto conical portions 15, each portion of which increases in diameter in a direction downstream of the direction of pipe movement as it issues from extrusion die 10. The first electrode is accommodated within a spark chamber indicated generally at 16 comprising a substantially rectilinear housing 17 having a lower housing portion 18 and an upper housing portion 19 hinged along a longitudinal edge 20 so that the upper housing portion 19 can hinge about hinge line 20 to permit access to a tube passing through chamber 16.

Internally of chamber 16 there is provided an outer or second electrode support (not shown) carrying a longitudinal frame indicated generally at 21 having a plurality of chains 22 depending from frame 21 and adapted to overlie and contact the outer surface of pipe 12 in the vicinity of the frusto conical portions 15 of first electrodes 13. The longitudinal frame 21 and the associated chains 22 are connected to a high voltage source (not shown) via means of a voltmeter 23, while the longitudinal cylindrical bar 14 constituting first electrode 13 is connected to earth. In a specific example the means for supplying the voltage is a DC or AC sparker of 15 k.volt capacity marketed by Hipotronics Inc. under Model No: 415.

This device permits the applied voltage to the chains 22 to be controlled up to 15 k.volts, ie: 15,000 volts. The applied voltage is indicated both on the control box and on the volt meter 23.

In operation the cross-linked polyethylenic pipe 12 is extruded from the die 10 and is at an elevated temperature, ie: of the order of 150 to 200°C. The pipe enters and passes over the first electrode 13 and through the spark chamber 16 to be contacted by the plurality of chains 22 which effectively provide an electrode contact over the length of the tube. The voltage applied between the first and second electrodes 13 and chains 22 is increased until spark discharge is obtained and a warning is indicated by warning means (not shown) that a discharge has occurred. The voltage is turned back on a DC sparker until a stable/ potential is maintained without discharge occurring. If, during extrusion of pipe 12 imperfections, such for example, a fall in the degree of crosslinking or a speck of dust or small bubble is formed in the wall of the pipe, the imperfection will be sensed within the spark chamber and a discharge will occur indicating the imperfection in the pipe. This may have the effect of sounding an alarm and automatically switching off the applied voltage and earthing the various components to allow the upper housing portion 19 to be hinged about hinge 20 for an operative to gain access to the pipe and to mark the area of the pipe where the discharge has occurred.

By controlling the quality of the cross-linked pipe
formed in the manner described above it is possible
to provide pipe having a much longer useful life
and significantly improved quality control over the previous
manufacture of cross-linked polyethylenic pipe.

- 1 -

CLAIMS:

1.    A method of testing the degree of crosslinking of an extruded crosslinked polyolefinic material which method comprises subjecting the material to a voltage above 1000 volts at a temperature above 100°C. in order to detect non-activated free valencies thereby providing an indication of the degree of crosslinking of the material.

2.    In a method of forming a shaped article of a cross-linked polyolefinic material by forming a mixture of a thermoplastic olefinic material capable of forming a free radical with a crosslinking agent therefor, working the material under pressure in a shaping and crosslinking apparatus to produce a uniform temperature rise within the mixture to a temperature at which the material can be extruded but at which substantial crosslinking does not occur, and thereafter shaping the material and initiating the crosslinking reaction and allowing the cross-linking reaction to proceed substantially to completion; the improvement comprising subjecting the crosslinked material on leaving said apparatus to a high voltage of at least 1000 volts at a temperature greater than 100°C. to detect non-activated free valencies thereby providing an indication of the degree of crosslinking.

3,     A method according to claim 1 or claim 2 wherein the material is in tubular form and is heated to a temperature above that to which it would be subjected in normal use.

4.     A method according to anyone of the foregoing claims wherein the voltage applied is just below the level at which discharge will occur for a normal sound wall of a desired degree of crosslinking at a given test temperature.

5.     A method according to either of claims 3 or 4 wherein the voltage is applied between an exterior electrode disposed to the exterior of the tube, and an interior electrode disposed within said tube.

6.     A method according to any one of the preceding claims wherein the voltage is applied immediately downstream of the forming die.

7.     A method according to any one of claims 1 to 5 wherein when the crosslinked material has been cooled, the inner electrode is constituted by heated electrically conductive liquid.

8.     A method according to claim 5 wherein the inner electrode is a metal rod and the exterior electrode comprises a plurality of metallic brush fibres or chains extending over the exterior surface of the tube.

9.    An apparatus adapted for use in the method of any one
of claims 1 to 8 which comprises means for heating a cross-
linked polyolefinic material to a temperature in excess of 100°C.
and means for applying a voltage above 1000 volts across said
material, and means for indicating any discharge occuring
across said material.

0047597

European Patent
Office

**EUROPEAN SEARCH REPORT**

Application number

EP 81 30 3801.5

## DOCUMENTS CONSIDERED TO·BE RELEVANT

| Category | Citation of document with indication, where appropriate, of relevant passages | Relevant to claim |
|---|---|---|
| | US − A − 3 418 570 (H.H. CLINTON)<br>* claims 1, 8, column 3, lines 30 to 32; column 4, lines 33 to 38; fig. 1 * | 1,2, 4-6, 8,9 |
| | − − − | |
| | US − A − 3 821 640 (G. BAHDER et al.)<br>* claims 1, 2, 4, 6, 16, column 1, lines 40 to 44; column 4, lines 29 to 34; column 5, lines 58 to 62; fig. 1 * | 1-3, 5,7 |
| | − − − | |
| P | US − A − 4 241 304 (H.H. CLINTON)<br>* claims 1, 3 to 11, 14 to 17, column 2, lines 66 to 69; column 3, lines 1 to 20; fig. 1 * | 1,2, 5,8, 9 |
| | − − − | |
| | GB − A − 1 318 793 (PIRELLI)<br>* claims 1, 2; page 1, lines 10 to 17; page 2, lines 12 to 20; fig. 1, 2 * | 1,3,5, 8,9 |
| | − − − | |
| | DE − C − 975 957 (ELEKTRO-SCHMITZ)<br>* claim 1; page 3, lines 16 to 21; fig. 1 * | 8,9 |
| | − − − | |
| D | US − A − 3 710 241 (W.R. DINEEN)<br>* claim 1; fig. 1 * | 1,6,9 |
| | − − − | |
| | ./.. | |

**CLASSIFICATION OF THE APPLICATION (Int. Cl.³)**

G 01 R 31/02
G 01 R 31/12
G 01 R 31/18
B 29 F 3/04

**TECHNICAL FIELDS SEARCHED (Int. Cl.³)**

B 29 D 23/00
B 29 F 3/00
C 08 J 3/00
C 08 J 27/00
G 01 N 27/00
G 01 N 33/00
G 01 R 31/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| Berlin | 28-10-1981 | FINDELI |

| | European Patent Office | **EUROPEAN SEARCH REPORT** | Application number |
|---|---|---|---|
| | | | EP 81 30 3801.5 |
| | | | – page 2 – |

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | US – A – 3 045 281 (M. SKOBEL) <br> * claim 1; column 4, lines 14 to 17; fig. 1b * <br> --- | 5,8,9 | |
| A | DE – A1 – 2 733 265 (Y. KOGYOSHO CO.) <br> & US – A – 4 224 560 <br> --- | | |
| A | DE – C – 826 468 (SIEMENS AG) <br> --- | | |
| A | US – A – 2 894 204 (R.D. GAMBRILL) <br> --- | | TECHNICAL FIELDS SEARCHED (Int. Cl.³) |
| A | US – A – 2 456 704 (G. E. HENNING) <br> --- | | |
| A | GB – A – 761 241 (M. MACKENZIE) <br><br> ----- | | |

EPO Form 1503.2  06.78